# FASCICULE DE BREVET EUROPEEN

(11) **EP 3 358 926 B1**
(45) Date de publication et mention de la délivrance du brevet: **20.11.2024**
(21) Numéro de dépôt: 18153892.7
(22) Date de dépôt: 29.01.2018
(51) Int. Cl.: H05B 45/00, H05B 45/37, H05B 47/10, H05K 5/00, H05K 9/00

(54) **DISPOSITIF DE PILOTAGE DE L'ALIMENTATION ELECTRIQUE POUR UNE SOURCE LUMINEUSE A SEMI-CONDUCTEUR**
VORRICHTUNG ZUR STEUERUNG DER STROMVERSORGUNG FÜR EINE LEUCHTQUELLE MIT HALBLEITER
DEVICE FOR CONTROLLING THE ELECTRIC POWER SUPPLY FOR A SEMICONDUCTOR LIGHT SOURCE

(30) Priorité: 02.02.2017 FR 1750854
(43) Date de publication de la demande: 08.08.2018
(73) Titulaire: Valeo Vision, 93012 Bobigny Cedex (FR)
(72) Inventeur: BADIA, Olivier, 93012 BOBIGNY Cedex (FR)
(74) Mandataire: Valeo Visibility

(56) Documents cités:
- FR-A1- 2 933 567
- US-A- 6 031 732
- US-B1- 6 191 475
- US-B1- 6 624 432

## Description

### DOMAINE TECHNIQUE DE L'INVENTION

La présente invention concerne un dispositif de pilotage de l'alimentation électrique pour une source lumineuse à semi-conducteur.

Elle trouve une application particulière mais non limitative dans les modules lumineux pour véhicule automobile.

### ARRIÈRE-PLAN TECHNOLOGIQUE DE L'INVENTION

Un dispositif de pilotage de l'alimentation électrique pour une source lumineuse à semi-conducteur comprend de manière connue de l'homme du métier une carte à circuit imprimé comportant au moins un composant électronique pour le pilotage de l'alimentation électrique. La carte à circuit imprimé est logée dans un boîtier fermé par un capot de protection et ladite carte à circuit imprimé repose sur ledit boîtier.

Afin d'effectuer une reprise de masse de la carte à circuit imprimé, à savoir une connexion de la carte à circuit imprimé à un plan de masse, il est connu d'utiliser un pion de sertissage ou une vis. Ce pion de sertissage ou cette vis est respectivement serti ou vissée au centre de la carte à circuit imprimé et traverse ladite carte à circuit imprimé jusqu'au plan de masse. Un inconvénient de cet état de la technique est que la carte à circuit imprimé peut se casser sous l'effet conjugué de contraintes provenant du pion de sertissage ou de la vis, et du boîtier, spécialement dans le cas où le boîtier est réalisé dans un matériau dur (par exemple, plus dur que l'aluminium). Une autre manière de connecter de masse de la carte à circuit imprimé avec le boîtier est connue du document US 6 191 475.

Dans ce contexte, la présente invention vise à proposer une solution différente de l'état de la technique antérieur, pour effectuer une reprise de masse compatible avec une plage plus ample de duretés du matériau du boîtier.

### DESCRIPTION GENERALE DE L'INVENTION

A cette fin l'invention propose un dispositif de pilotage de l'alimentation électrique pour une source lumineuse à semi-conducteur pour un module lumineux selon la revendication 1.

Ainsi, comme on va le voir en détail ci-après, pour la reprise de masse, on a remplacé le pion de sertissage par une pluralité de points de contact (les premiers et deuxièmes points de contact) avec deux ceintures de masse. Grâce aux premiers points de contact avec la deuxième ceinture de masse et aux deuxièmes points de contact avec la première ceinture de masse, on s'assure d'une bonne reprise de masse de la carte à circuit imprimé. En outre, les premiers points de contact et les deuxièmes points de contact assurent ponctuellement le support de la carte à circuit imprimé dans le boîtier. On limite alors les risques de détérioration de ladite carte à circuit imprimé dans ledit boîtier. Par ailleurs, ledit muret agit comme un moyen de protection de ces premiers points de contact et/ou de ces deuxièmes points de contact au cours de la fabrication du boîtier et/ou de la fabrication du capot de protection.

Selon des modes de réalisation non limitatifs, le dispositif de pilotage peut comporter en outre une ou plusieurs caractéristiques supplémentaires parmi les suivantes :
Selon un mode de réalisation non limitatif, les premiers points de contact et les deuxièmes points de contact sont régulièrement répartis respectivement sur une première zone de contact et sur une deuxième zone de contact dudit boitier et dudit capot de protection avec ladite carte à circuit imprimé.

Selon un mode de réalisation non limitatif, ledit dispositif de pilotage comprend au moins une vis adaptée pour maintenir fermé ledit boîtier.

Selon un mode de réalisation non limitatif, ledit boîtier et/ou ledit capot de protection comprend une zone chanfreinée primaire.

Selon un mode de réalisation non limitatif, ledit boîtier et/ou ledit capot de protection comprend une zone chanfreinée secondaire.

Selon un mode de réalisation non limitatif, il existe une zone de recouvrement entre ledit boîtier et ledit capot de protection lorsque ledit boîtier est fermé par ledit capot de protection.

Selon un mode de réalisation non limitatif, ladite zone de recouvrement comprend une hauteur supérieure ou égale à 1 mm.

Selon un mode de réalisation non limitatif, la source lumineuse à semi-conducteur fait partie d'une diode électroluminescente.

Il est également proposé un module lumineux pour véhicule automobile dans lequel ledit module lumineux comprend une source lumineuse à semi-conducteur et un dispositif de pilotage de l'alimentation électrique pour ladite source lumineuse à semi-conducteur selon l'une quelconque des caractéristiques précédentes.

### BREVE DESCRIPTION DES FIGURES

L'invention et ses différentes applications seront mieux comprises à la lecture de la description qui suit et à l'examen des figures qui l'accompagnent.
- la figure 1 représente une vue en perspective d'un dispositif de pilotage de l'alimentation électrique pour une source lumineuse à semi-conducteur selon un mode de réalisation non limitatif de l'invention ;
- la figure 2 représente une vue éclatée du dispositif de pilotage de la figure 1 selon un mode de réalisation non limitatif ;
- la figure 3 représente schématiquement une vue interne d'un capot de protection du dispositif de pilotage des figures 1 et 2 selon un mode de réalisation non limitatif ;
- la figure 4 représente schématiquement une vue interne d'un boîtier du dispositif de pilotage des figures 1 et 2 selon un mode de réalisation non limitatif, ledit boîtier étant adapté pour être fermé par le capot de protection de la figure 3 ;
- la figure 5 représente schématiquement une vue de dessus d'une carte à circuit imprimé du dispositif de pilotage des figures 1 et 2 selon un mode de réalisation non limitatif ;
- la figure 6 représente schématiquement une vue de dessous de la carte à circuit imprimé du dispositif de pilotage des figures 1 et 2 selon un mode de réalisation non limitatif ;
- la figure 7 représente schématiquement une vue en coupe du dispositif de pilotage selon un mode de réalisation non limitatif, selon une coupe A-A de la figure 1 ;
- la figure 8 est un zoom d'une partie de la vue en coupe de la figure 7 ;
- la figure 9 représente une vue en perspective du dispositif de pilotage des figures 1 et 2 sans son capot de protection, ledit dispositif de pilotage coopérant avec un connecteur bord de carte selon un mode de réalisation non limitatif ;
- la figure 10 représente le dispositif de pilotage de la figure 9 sans connecteur bord de carte ;
- la figure 11 représente une vue en perspective du dispositif de pilotage des figures 1 et 2 ;
- la figure 12 représente le dispositif de pilotage de la figure 11, ledit dispositif de pilotage coopérant avec un connecteur bord de carte selon un mode de réalisation non limitatif ;
- la figure 13 représente le dispositif de pilotage de la figure 12, ledit dispositif de pilotage coopérant en outre avec un faisceau d'alimentation selon un mode de réalisation non limitatif ;
- la figure 14 représente le dispositif de pilotage de la figure 13 dans lequel le faisceau d'alimentation est bloqué dans le connecteur bord de carte par une pièce de blocage selon un mode de réalisation non limitatif.

### DESCRIPTION DE MODES DE REALISATION DE L'INVENTION

Les éléments identiques, par structure ou par fonction, apparaissant sur différentes figures conservent, sauf précision contraire, les mêmes références.

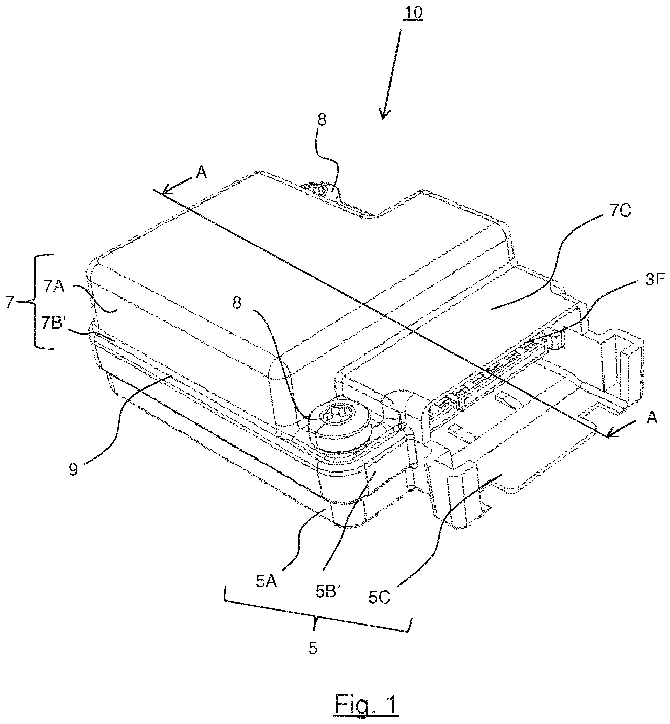

Le dispositif de pilotage 10 selon l'invention est décrit en référence aux figures 1 à 14. Ce dispositif de pilotage 10 est adapté pour piloter l'alimentation électrique d'une source lumineuse à semi-conducteur pour un module lumineux (non illustré).

Dans un mode de réalisation non limitatif, le module lumineux est un dispositif d'éclairage et/ou de signalisation pour véhicule automobile.

Ce module lumineux comprend le dispositif de pilotage 10 ainsi qu'au moins une source lumineuse à semi-conducteur.

Dans des modes de réalisation non limitatifs, le module lumineux est adapté pour assurer une fonction photométrique :
- dite « High Beam » en anglais pour réaliser un feu de route ; et/ou
- dite « Low Beam » en anglais pour réaliser, par exemple, un feu de croisement ; et/ou
- dite DRL pour réaliser un feu diurne ; et/ou
- dite « Turn Indicator » en anglais pour réaliser un feu de signalisation. Dans un mode de réalisation non limitatif, la source lumineuse à semi-conducteur fait partie d'une diode électroluminescente. Par diode électroluminescente, on entend tout type de diodes électroluminescentes, que ce soit dans des exemples non limitatifs des LED (« Light Emitting Diode »), une OLED (« Organic LED ») ou une AMOLED (« Active-Matrix-Organic LED »), ou encore une FOLED (« Flexible OLED »).

Par véhicule automobile, on entend tout type de véhicule motorisé.

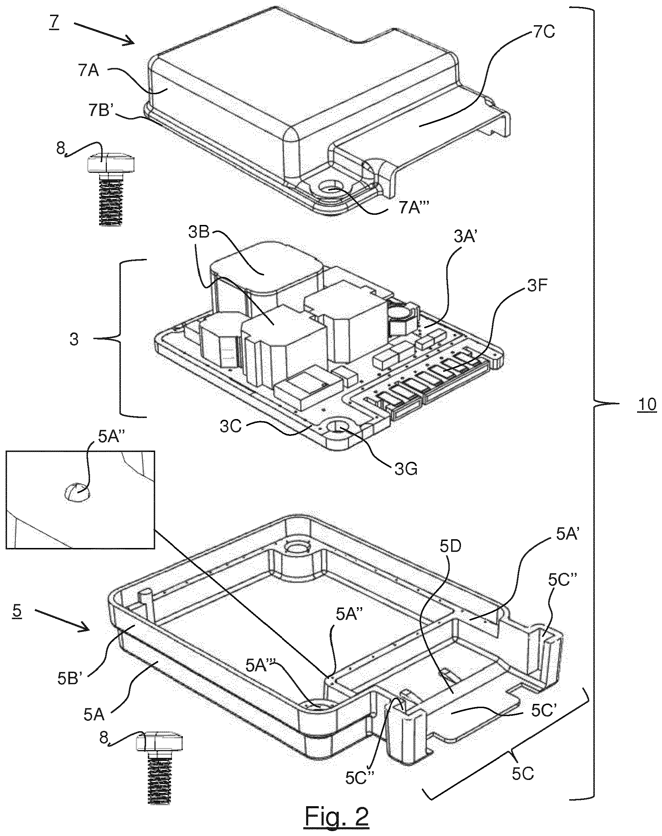

Tel qu'illustré sur la figure 2, le dispositif de pilotage 10 comprend :
- une carte à circuit imprimé 3 ;
- un boîtier 5 ;
- un capot de protection 7.

Le boîtier 5 et le capot de protection 7 forment l'enveloppe du dispositif de pilotage 10. Ils sont adaptés pour coopérer avec au moins une vis 8. Ladite au moins une vis 8 est ainsi adaptée pour assembler l'ensemble capot de protection 7, carte à circuit imprimé 3 et boîtier 5, la carte à circuit imprimé 3 étant prise en sandwich entre le capot de protection 7 et le boîtier 5.

Dans un mode de réalisation non limitatif, le dispositif de pilotage 10 comprend une largeur inférieure ou également à 80mm (millimètres), une longueur inférieure ou également à 80mm, une épaisseur inférieure ou également à 20mm. On notera que ce format est un format relativement petit pour un dispositif de pilotage 10.

Comme on va le voir ci-après, la reprise de masse est réalisée par des premiers et deuxièmes points de contacts entre l'enveloppe 5-7 du dispositif de pilotage 10 et la carte à circuit imprimé 3.

On rappelle qu'une reprise de masse est une connexion électrique qui est faite entre une carte à circuit imprimé, des pièces mécaniques massives et la borne négative d'une batterie du véhicule automobile. Une reprise de masse permet de réaliser un blindage CEM pour les composants électroniques du dispositif de pilotage 10.

Les différents éléments du dispositif de pilotage 10 sont décrits en détail ci-après.

### • Carte à circuit imprimé 3

Comme il est illustré plus particulièrement aux figures 2, et 5 à 8, la carte à circuit imprimé 3 comporte :
- une plaque de base 3A ;
- au moins un composant électronique 3B ;
- une première ceinture de masse 3C et une deuxième ceinture de masse 3D ;
- au moins une piste de connexion 3F.

La carte à circuit imprimé 3 est adaptée pour être logée dans le boîtier 5. Les éléments de la carte à circuit imprimé 3 sont décrits en détail ci-dessous.

### ∘ Plague de base 3A

Dans un mode de réalisation non limitatif, la plaque de base 3A est constituée d'une feuille de résine époxy collée entre des couches de cuivre. Elle comporte des pistes cuivrées (non illustrées).

La carte à circuit imprimé 3, et plus particulièrement la plaque de base 3A de cette carte à circuit imprimé 3, comporte une première face 3A' (appelée également face supérieure) et une deuxième face 3A" (appelée également face inférieure) opposée à la première face 3A'.

La plaque de base 3A comprend un orifice 3G adapté pour le passage d'une vis 8. La vis 8 est adaptée pour la fixation du capot de protection 7 sur le boîtier 5 de sorte que la carte à circuit imprimé 3 est prise en sandwich entre le capot de protection 7 et le boîtier 5.

On notera que sur la première face 3A' et sur la deuxième face 3A" de la carte à circuit imprimé 3, la première ceinture de masse 3C et la deuxième ceinture de masse 3D entourent ledit orifice 3G.

Dans un mode de réalisation non limitatif, la carte à circuit imprimé 3, en particulier sa plaque de base 3A comprend des trous métallisés (également appelés vias) adaptés pour effectuer des interconnexions CEM dans la carte à circuit imprimé 3. Cela permet de réaliser une troisième cage de Faraday (les deux autres étant décrites plus loin) pour les pistes cuivrées de la carte à circuit imprimé 3 qui peuvent émettre également un rayonnement dit CEM. Par conséquent un blindage CEM pour lesdites pistes cuivrées est réalisé. Cette troisième cage de Faraday permet ainsi de protéger les autres organes du véhicule automobile contre un rayonnement CEM des pistes cuivrées, mais elle permet également de protéger les pistes cuivrées elles-mêmes contre un rayonnement CEM des autres organes du véhicule automobile.

### ∘ Composant électronique 3B

Au moins une des faces 3A', 3A" de la plaque de base 3A comprend un composant électronique 3B adapté pour le pilotage de l'alimentation électrique d'une source lumineuse. Dans un mode de réalisation non limitatif, la carte à circuit imprimé 3 comprend une pluralité de composants électroniques 3B. Dans des modes de réalisation non limitatifs, les composants électroniques 3B sont un transistor MOSFET, un convertisseur DC/DC etc.

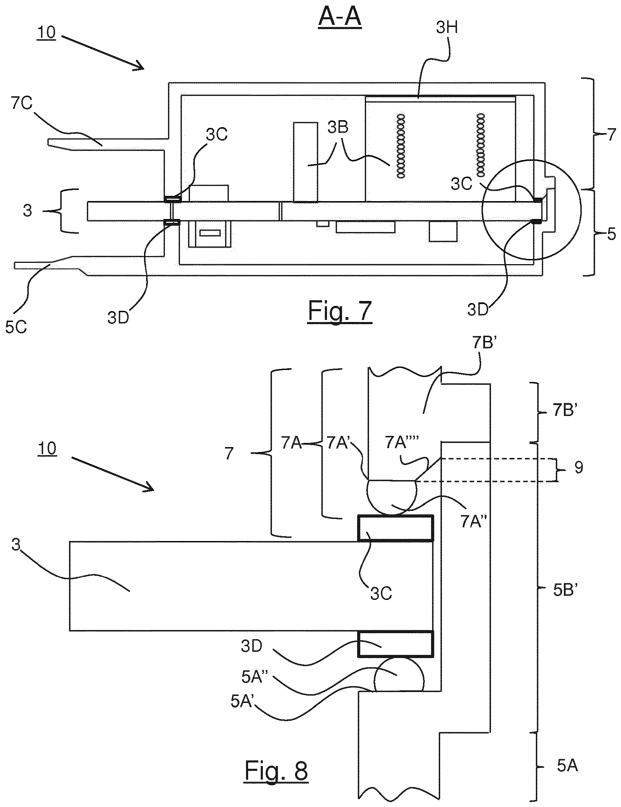

Dans un mode de réalisation non limitatif, un composant électronique 3B est recouvert d'une pâte thermique 3H (illustrée sur la figure 7) adaptée pour transférer la chaleur. La dissipation thermique dudit composant électronique 3B est ainsi améliorée. On notera que le dispositif de pilotage 10 comprend une pâte thermique 3H associée aux composants électroniques 3B qui chauffent le plus.

### ∘ Première ceinture de masse 3C etdeuxième ceinturede masse 3D

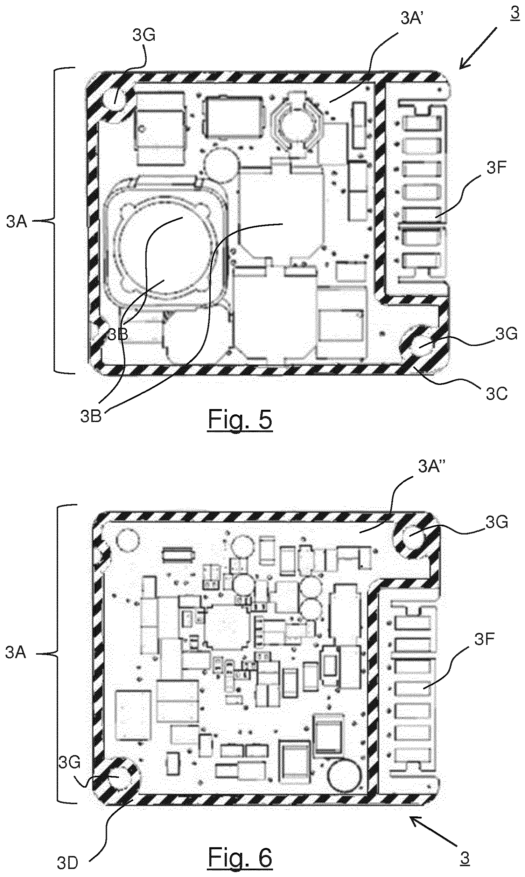

La première ceinture de masse 3C et la deuxième ceinture de masse 3D (zones hachurées sur les figures 5 et 6) permettent avec les premiers points de contact 5A" et les deuxièmes points de contact 7A" d'effectuer une reprise de masse de la carte à circuit imprimé 3. La première ceinture de masse 3C est disposée sur la première face 3A' de la carte à circuit imprimé 3 et la deuxième ceinture de masse 3D est disposée sur la deuxième face 3A" de la carte à circuit imprimé 3. Ce sont des parties conductrices.

Dans un mode de réalisation non limitatif, la première ceinture de masse 3C et la deuxième ceinture de masse 3D sont réalisées dans un même matériau. Dans une variante de réalisation non limitative, le matériau est de l'étain. Dans un mode de réalisation non limitatif, la première ceinture de masse 3C et la deuxième ceinture de masse 3D sont ainsi étamées sur la carte à circuit imprimé 3. On notera que dans le mode de réalisation non limitatif décrit plus loin où le boîtier 5 (et les premiers points de contact 5A") et le capot de protection 7 (et les deuxièmes points de contact 7A") sont en Zamak, on a un contact entre un matériau dur (le Zamak) et un matériau plus mou (l'étain). Cela permet d'avoir un meilleur contact.

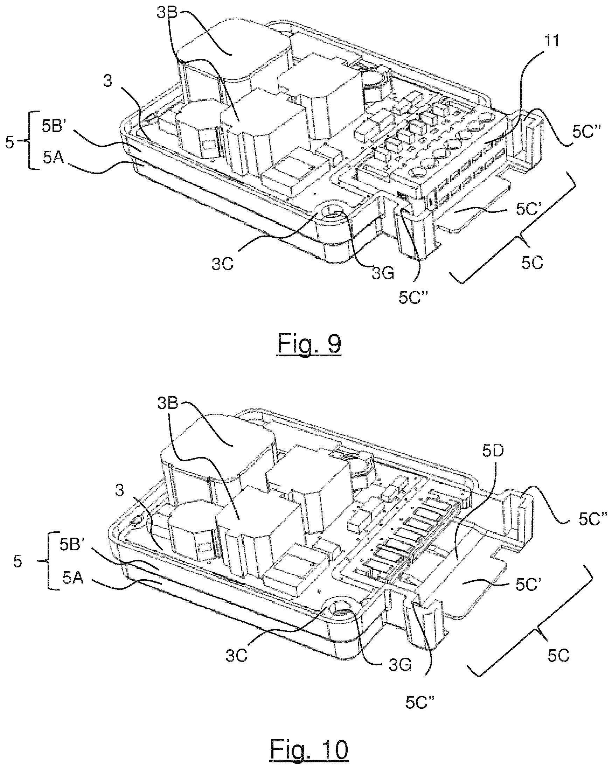

La première ceinture de masse 3C et la deuxième ceinture de masse 3D sont mises à la masse via la borne négative (non illustrée) d'une batterie du véhicule automobile. A cet effet, la borne négative est connectée sur le connecteur bord de carte 11 (illustré figure 9) qui lui-même est relié à la première ceinture de masse 3C et la deuxième ceinture de masse 3D.

La première ceinture de masse 3C et la deuxième ceinture de masse 3D ont sensiblement le même tracé sur la première face 3A' et sur la deuxième face 3A". Plus particulièrement, la première ceinture de masse 3C et la deuxième ceinture de masse 3D s'étendent respectivement sur le pourtour de la première face 3A' et sur le pourtour de la deuxième face 3A".

### ∘ Piste de connexion 3F

La carte à circuit imprimé 3 comprend au moins une piste de connexion 3F. Dans un mode de réalisation non limitatif, elle comprend une pluralité de pistes de connexion 3F.

Une piste de connexion 3F est adaptée pour l'alimentation électrique de la carte à circuit imprimé 3. La piste de connexion 3F vient ainsi coopérer avec un connecteur bord de carte 11 (appelé en anglais « cardedge ») qui comprend de manière connue de l'homme du métier une mâchoire équipée d'au moins un contact adapté pour entrer en contact avec la piste de connexion 3F de la carte à circuit imprimé 3 de sorte à connecter cette dernière à un faisceau d'alimentation 13. On rappelle que le faisceau d'alimentation 13 est adapté pour alimenter le dispositif de pilotage 10, ce dernier redistribuant la puissance d'alimentation vers les sources lumineuses à semi-conducteur qu'il pilote.

Dans un mode de réalisation non limitatif, la piste de connexion 3F est une piste métallique. Tel qu'illustré sur les figures 5 et 6, on notera que sur la première face 3A' et sur la deuxième face 3A" de la carte à circuit imprimé 3, la première ceinture de masse 3C et la deuxième ceinture de masse 3D contournent la piste de connexion 3F.

### • Boîtier 5

Le boîtier 5 est adapté pour dissiper thermiquement la chaleur dégagée par les composants électronique 3B de la carte à circuit imprimé 3.

Par ailleurs, il a également pour fonction avec le capot de protection 7 de prendre en sandwich la carte à circuit imprimé 3.

Dans un mode de réalisation non limitatif, ce boîtier 5 est obtenu au cours d'un procédé d'injection. Dans un mode de réalisation non limitatif, le boîtier 5 est en Zamak. On notera que le Zamak est un alliage de zinc, d'aluminium, de magnésium et de cuivre. Cet alliage est plus dur que l'aluminium. On notera que le Zamak a une capacité de dissipation thermique proche de celle de l'aluminium. Dans un mode de réalisation non limitatif, le Zamak injecté comporte une dissipation thermique sensiblement égale à 110Watts/mètre/Kelvin comme l'aluminium injecté.

Pour un procédé de fabrication par injection, le Zamak permet d'obtenir des pièces avec des épaisseurs plus faibles qu'avec de l'aluminium.

Par ailleurs, le Zamak permet d'obtenir des pièces par injection plus petites, plus précises, plus complexes et plus dures qu'avec de l'aluminium. Notamment, les premiers points de contacts 5A" obtenus sont plus précis et plus robustes.

On notera que le temps de cycle de fabrication d'un dispositif de pilotage 10 en Zamak est inférieur à celui d'un dispositif de pilotage 10 en aluminium. Ainsi, dans un exemple non limitatif, le temps de cycle de fabrication pour du Zamak est sensiblement égal à 2 secondes tandis que celui pour de l'aluminium est sensiblement compris entre 30 et 40 secondes.

On notera que le Zamak comprend une densité de 6,8 tandis que l'aluminium comporte une densité de 2,7. Le Zamak est ainsi plus lourd que l'aluminium. Cependant, comme il est possible d'obtenir un boîtier 1,5 à 5 fois moins épais qu'avec de l'aluminium, le poids du boîtier 5 revient au même que s'il était fabriqué en aluminium.

Comme il est illustré aux figures 1, 2, 4, 7-12, le boîtier 5 comprend :
- un premier corps de base 5A ;
- un premier muret de protection 5B' ;
- une zone de réception 5C.

Dans un mode de réalisation non limitatif (non illustré), le boîtier 5 comprend une zone chanfreinée primaire pour faciliter la fermeture dudit boîtier 5 par le capot de protection 7. La zone chanfreinée primaire facilite la mise en place du capot de protection 7 sur le boitier 5 et cela permet ainsi de réaliser un bon montage mécanique du capot de protection 7 et du boîtier 5. Dans une variante de réalisation non limitative, le premier muret de protection 5B' comprend ladite au moins une zone chanfreinée primaire adaptée pour la fermeture du boîtier 5 par le capot de protection 7.

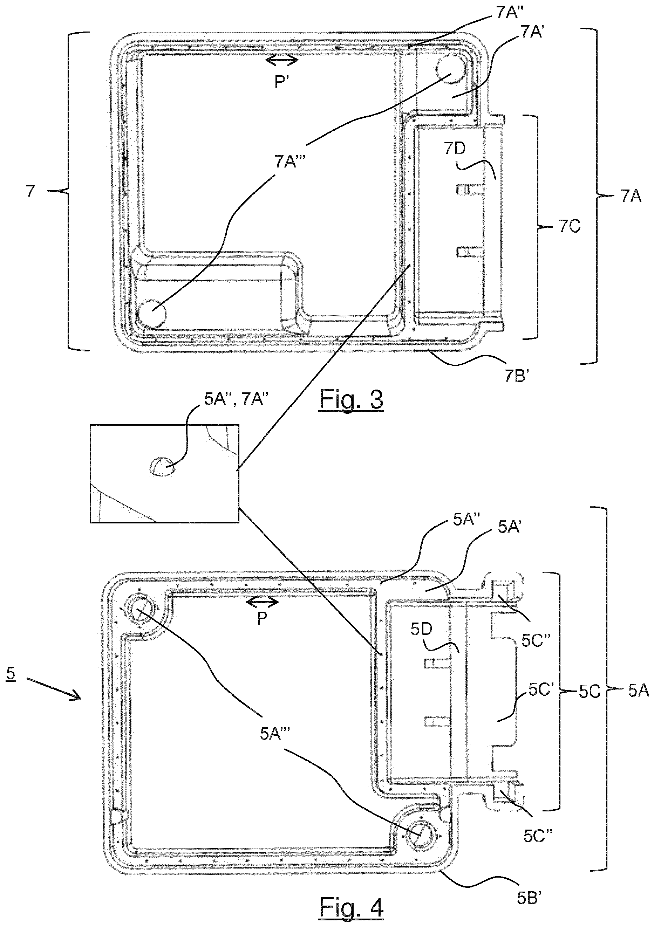

Dans un mode de réalisation non limitatif, le boîtier 5 comprend une zone chanfreinée secondaire 5D (illustrée sur la figure 4 par exemple) adaptée pour guider le connecteur bord de carte 11 et faciliter sa mise en place sur le boîtier 5.

Les éléments du boîtier 5 sont décrits en détails ci-après.

### ∘ Premier corps de base 5A

Le premier corps de base 5A du boîtier 5 délimite l'espace interne dans lequel la carte à circuit imprimé 3 est accueillie. Le premier corps de base 5A du boîtier 5 comprend :
- une première zone de contact 5A' comprenant des premiers points de contact 5A" ;
- au moins un trou taraudé 5A‴.

Le trou taraudé 5A'" est adapté pour recevoir la vis 8 pour la fixation du capot de protection 7 sur le boîtier 5. On notera que des premiers points de contact 5A" sont disposés autour de ce trou taraudé 5A‴. Dans un mode de réalisation non limitatif représenté à la figure 4, le premier corps de base 5A du boîtier 5 comprend deux trous taraudés 5A'".

La première zone de contact 5A' est adaptée pour recevoir la carte à circuit imprimée 3 dans le boitier 5. Les premiers points de contact 5A" sont répartis sur la première zone de contact 5A'.

Ces premiers points de contact 5A" assurent ponctuellement le support de la carte à circuit imprimé 3 dans le boîtier 5. La carte à circuit imprimé 3 repose en effet sur eux. Dans un mode de réalisation non limitatif illustré sur les figures 7 et 8, lorsque la carte à circuit imprimé 3 est positionnée dans le boîtier 5, les premiers points de contact 5A" sont en contact avec la deuxième ceinture de masse 3D de la carte à circuit imprimé 3. La deuxième ceinture de masse 3D appuie directement sur les premiers points de contact 5A".

Par ailleurs, les premiers points de contact 5A" assurent un contact dit CEM (avec la carte à circuit imprimé 3) qui permet d'éviter au dispositif de pilotage 10 d'émettre des ondes électromagnétiques qui perturbent les autres organes du véhicule automobile (tels que la radio, le système de navigation etc. dans des exemples non limitatifs). Par ailleurs, ce contact dit CEM évite également au dispositif de pilotage 10 d'être perturbé par une source rayonnée externe, telle que les autres organes du véhicule automobile qui émettent également des ondes électromagnétiques.

Ce phénomène bien connu de l'homme du métier est appelé problème de comptabilité électromagnétique (CEM).

Ainsi, les premiers points de contact 5A" permettent de réaliser une connexion électrique entre la carte à circuit imprimé 3 (via la deuxième ceinture de masse 3D) et le boîtier 5. La reprise de masse est ainsi assurée. Les premiers points de contact 5A" étant en contact avec une partie conductrice (la deuxième ceinture de masse 3D) de la carte à circuit imprimé 3, partie conductrice qui est elle-même reliée à la borne négative de la batterie, cela permet de créer une première cage de Faraday et par conséquent un blindage CEM pour les composants électroniques 3B de la carte à circuit imprimé 3 qui se trouvent sur sa deuxième face 3A". Les composants électroniques 3B qui émettent un rayonnement dit CEM sont ainsi encapsulés dans cette première cage Faraday.

Cette première cage de Faraday permet ainsi de protéger les autres organes du véhicule automobile contre un rayonnement CEM des composants électroniques 3B de la carte à circuit imprimé 3 qui se trouvent sur sa deuxième face 3A", mais elle permet également de protéger ces composants électroniques 3B eux-mêmes contre un rayonnement CEM des autres organes du véhicule automobile.

On notera que sans la présence des premiers points de contact 5A", si la carte à circuit imprimé 3 (et donc la deuxième ceinture de masse 3D) reposait directement sur la première zone de contact 5A' du boîtier 5, il pourrait y avoir des fuites CEM. En effet, il peut y avoir des défauts de planéité de la première zone de contact 5A' et/ou de la deuxième ceinture de masse 3D qui peut entraîner l'apparition d'une zone de non contact entre deux zones de contact. De ce fait, il peut exister une distance telle entre ces deux zones de contact que cela peut entraîner des fuites CEM au niveau de la zone de non contact. La présence des premiers points de contact 5A" permet de maîtriser le problème de CEM car on peut déterminer précisément la distance P (appelée également pas) entre deux points de contact 5A" comme expliqué plus loin.

Dans un mode de réalisation non limitatif illustré à la figure 4, les premiers points de contact 5A" ont une forme arrondie. C'est une forme facile à mouler.

Dans un mode de réalisation non limitatif, les premiers points de contact 5A" sont régulièrement répartis sur la première zone de contact 5A'. Cela permet d'obtenir un appui régulier sur la carte à circuit imprimé 3

Dans un mode de réalisation non limitatif, les premiers points de contacts 5A" s'étendent sur le pourtour du boîtier 5 de sorte qu'ils se retrouvent en regard de la deuxième ceinture de masse 3D de la carte à circuit imprimé 3 lorsque cette dernière est placée dans le boîtier 5.

Comme il est illustré à la figure 4, tout ou partie des premiers points de contact 5A" sont ainsi alignés entre eux avec un pas P constant. Dans un exemple non limitatif, le pas P est compris entre 3 et 5mm (millimètres).

La répartition de pression est ainsi constante sur la carte à circuit imprimé 3 lors de la fermeture du boîtier 5 par le capot de protection 7. On favorise ainsi un maintien équilibré de la carte à circuit 3 imprimé dans le boîtier 5 et on limite les risques de détérioration de ladite carte à circuit imprimé 3 dans ledit boîtier 5. Dans un mode de réalisation non limitatif, les premiers points de contact 5A" sont moulés avec le boîtier 5 et plus particulièrement avec la première zone de contact 5A'.

Dans un mode de réalisation non limitatif, les premiers points de contact 5A" sont en Zamak. L'utilisation du Zamak facilite le moulage des premiers points de contact 5A" à la géométrie souhaitée. En outre, avec le Zamak les premiers points de contact 5A" présentent une excellente dureté.

### ∘ Premier muret de protection 5B'

Le premier muret de protection 5B' prolonge verticalement le premier corps de base 5A du boîtier 5. Comme illustré sur la vue en coupe de la figure 7 et de la figure 8, dans un mode de réalisation non limitatif il existe un décrochement entre le premier corps de base 5A et le premier muret de protection 5B'. De cette manière, l'espace du boîtier 5 dans lequel vient s'insérer la carte à circuit imprimé 3 est agrandi ce qui facilite la mise en place de ladite carte à circuit imprimé 3 dans le premier corps de base 5A.

Le premier muret de protection 5B' est adapté pour s'emboîter avec le deuxième muret de protection 7B' du capot de protection 7. Il existe ainsi une zone de recouvrement 9 selon la direction verticale (illustrée figure 8, appelée également chevauchement) entre le boîtier 5 et le capot de protection 7 lorsque ledit boîtier 5 est fermé par ledit capot de protection 7.

Le premier muret de protection 5B' améliore ainsi le guidage du capot de protection 7 sur le boîtier 5 et permet une fermeture dudit boîtier 5 par ledit capot de protection 7.

On notera que la zone de recouvrement 9 est adaptée pour être conforme à des tests de décharges électrostatiques, dits tests ESD. Des décharges électrostatiques provenant de l'extérieur peuvent en effet perturber la carte à circuit imprimé 3. Dans un mode de réalisation non limitatif, la zone de recouvrement 9 comprend une hauteur supérieure ou égale à 1 mm. Cela permet de parer une décharge électrostatique allant jusqu'à 1000Volts.

Par ailleurs, grâce à la zone de recouvrement 9, le premier muret de protection 5B' est adapté pour réaliser une barrière complémentaire de protection CEM pour les composants électroniques 3B de la carte à circuit imprimé 3, en particulier pour ceux situés sur la deuxième face 3A".

Enfin, le premier muret de protection 5B' agit comme un moyen de protection de tout ou partie des premiers points de contact 5A" au cours de la fabrication du boîtier 5. Au cours de cette fabrication le boîtier 5 est soumis, après son injection à :
- une opération dite de dégrapage où les pièces du dispositif de pilotage 10 (le boîtier 5 et le capot de protection 7) avec le canal d'alimentation du moule sont désolidarisées entre elles. Lors de cette opération de dégrapage, elles entrent en contact entre elles ce qui risque d'abîmer les premiers points de contact 5A".
- une opération dite d'ébavurage. Cette opération d'ébavurage consiste en un nettoyage mécanique du boîtier 5 et permet également de le polir. A cet effet, ce dernier est mis dans un tonneau rotatif ce qui permet de supprimer des particules parasites qui pourraient se détacher du boîtier 5 lors du fonctionnement du dispositif de pilotage 10 et endommager la carte à circuit imprimé 3 en créant des courts-circuits. Le premier muret de protection 5B' protège les premiers points de contact 5A" de l'opération d'ébavurage, cette opération risquant sinon d'arracher les premiers points de contact 5A" ou de les endommager.

Les premiers points de contact 5A" qui sont protégés par le premier muret de protection 5B' ne sont pas enlevés ou abîmés et conservent ainsi leur forme pendant la fabrication du boîtier 5. On notera que les premiers points de contact 5A" qui sont proches du premier muret de protection 5B' sont protégés par ce muret de protection 5B'.

Dans un mode de réalisation non limitatif illustré sur la figure 4, une partie des premiers points de contacts 5A" sont protégés par le premier muret de protection 5B'. Ils sont situés en bas dudit premier muret de protection 5B'. Les autres premiers points de contacts 5A" qui ne sont pas protégés sont ceux qui se trouvent en regard du connecteur bord de carte 11 lorsque ce dernier est installé. Bien entendu, dans un autre mode de réalisation non limitatif, on peut prévoir de les protéger également.

On notera qu'après l'opération d'ébavurage, dans un mode de réalisation non limitatif, le boîtier 5 subit une opération de nettoyage qui permet d'enlever la graisse utilisée pour l'opération de démoulage.

### ∘ Zone de réception 5C

La zone de réception 5C est adaptée pour recevoir un connecteur bord de carte 11. Cette zone de réception 5C comprend :
- une partie de réception 5C' ;
- au moins une glissière verticale 5C".

La partie de réception 5C' de la zone de réception 5C est adaptée pour recevoir le connecteur bord de carte 11. Comme il est illustré aux figures 9 à 12, le connecteur bord de carte 11 vient en contact avec la piste de connexion 3F de la carte à circuit imprimé 3 pour l'alimentation électrique de ladite carte à circuit imprimé 3. Comme il a déjà été précisé, le connecteur bord de carte 11 est alimenté électriquement par le faisceau d'alimentation 13.

La glissière verticale 5C" est adaptée pour recevoir une pièce de blocage 15 du connecteur bord de carte 11 sur la carte à circuit imprimé 3. Dans un mode de réalisation non limitatif illustré aux figures 1, 2 9-12, la zone de réception 5C comprend deux glissières verticales disposée en vis-à-vis. On améliore ainsi la mise en place et le maintien de la pièce de blocage 15 dans le dispositif de pilotage 10.

### • Capot de protection 7

Le capot de protection 7 est adapté pour dissiper thermiquement la chaleur dégagée par les composants électronique 3B de la carte à circuit imprimé 3. Par ailleurs, il a également pour fonction avec le boîtier 5 de prendre en sandwich la carte à circuit imprimé 3.

Le capot de protection 7 est adapté pour fermer le boîtier 5. Dans un mode de réalisation non limitatif, le capot de protection 7 est obtenu au cours d'un procédé de fabrication par injection.

Dans un mode de réalisation non limitatif, le capot de protection 7 est en Zamak. Il est ainsi possible d'obtenir un capot de protection 7 de forme plus complexe et plus dur qu'avec l'aluminium. Notamment, les deuxièmes points de contacts 7A" obtenus sont plus précis et plus robustes.

Il est possible d'obtenir un capot de protection 7 moins épais qu'avec de l'aluminium. Le poids du capot de protection 7 revient au même que s'il était fabriqué en aluminium.

Comme il est illustré aux figures 1, 2, 3, 7-12, le capot de protection 7 comprend :
- un deuxième corps de base 7A ;
- un deuxième muret de protection 7B' ;
- une partie de protection 7C.

Dans un mode de réalisation non limitatif, le capot de protection 7 comprend au moins une zone chanfreinée primaire 7A"" pour la fermeture dudit boîtier 5 par le capot de protection 7. La zone chanfreinée primaire 7A"" facilite la mise en place du capot de protection 7 sur le boitier 5 et cela permet ainsi de réaliser un bon montage mécanique du capot de protection 7 et du boîtier 5. Dans une variante de réalisation non limitative, le deuxième muret de protection 7A' comprend ladite au moins une zone chanfreinée primaire 7A"". La zone chanfreinée primaire 7A"" s'étend à partir de la deuxième zone de contact 7A" jusqu'à l'extérieur du capot de protection 7. La zone chanfreinée primaire 7A"" facilite la mise en place du capot de protection 7 sur le boitier 5. A la figure 8, la zone chanfreinée primaire 7A"" est totalement positionnée dans le boitier 5, lorsque le boîtier 5 est fermé par le capot de protection 7.

De la même manière que pour le boîtier 5, dans un mode de réalisation non limitatif, le capot de protection 7 comprend au moins une zone chanfreinée secondaire 7D (illustrée sur la figure 3 par exemple) adaptée pour guider le connecteur bord de carte 11 et faciliter sa mise en place sous le capot de protection 7.

Les éléments du capot de protection 7 sont décrits en détails ci-après.

### ∘ Deuxième corps de base 7A

Le deuxième corps de base 7A du capot de protection 7 délimite un espace adapté pour venir recouvrir la carte à circuit imprimé 3 logée dans le boîtier 5. Le deuxième corps de base 7A comprend :
- une deuxième zone de contact 7A' comprenant des deuxièmes points de contact 7A" ;
- au moins un orifice 7A‴.

L'orifice 7A‴ est adapté pour laisser passer la vis 8 pour la fixation du capot de protection 7 sur le boîtier 5. Dans un mode de réalisation non limitatif représenté à la figure 3, le deuxième corps de base 7A du capot de protection 7 comprend deux orifices 7A‴.

La deuxième zone de contact 7A' est adaptée pour venir appuyer sur la carte à circuit imprimée 3 dans le boitier 5. Les deuxièmes points de contact 7A" sont répartis sur la deuxième zone de contact 7A'.

Ces deuxièmes points de contact 7A" assurent ponctuellement le maintien de la carte à circuit imprimé 3 dans le boîtier 5. Dans un mode de réalisation non limitatif illustré à la figure 7, lorsque le capot de protection 7 est positionné sur le boîtier 5, les deuxièmes points de contact 7A" sont en contact avec la première ceinture de masse 3C de la carte à circuit imprimé 3. Ils appuient directement sur cette première ceinture de masse 3C.

Par ailleurs, les deuxièmes points de contact 7A" assurent un contact dit CEM (avec la carte à circuit imprimé 3) qui permet d'éviter au dispositif de pilotage 10 d'émettre des ondes électromagnétiques qui perturbent les autres organes du véhicule automobile (tels que la radio, le système de navigation etc. dans des exemples non limitatifs). Par ailleurs, ce contact dit CEM évite également au dispositif de pilotage 10 d'être perturbé par une source rayonnée externe, telle que les autres organes du véhicule automobile qui émettent également des ondes électromagnétiques.

Ainsi, les deuxièmes points de contact 7A" permettent de réaliser une connexion électrique entre la carte à circuit imprimé 3 (via la première ceinture de masse 3C) et le capot de protection 7. La reprise de masse est ainsi assurée.

Les deuxièmes points de contact 7A" étant en contact avec une partie conductrice (la première ceinture de masse 3C) de la carte à circuit imprimé 3, partie conductrice qui est elle-même reliée à la borne négative de la batterie, cela permet de créer une deuxième cage de Faraday et par conséquent un blindage CEM pour les composants électroniques 3B de la carte à circuit imprimé 3 qui se trouvent sur sa première face 3A'. Les composants électroniques 3B qui émettent un rayonnement CEM sont ainsi encapsulés dans cette deuxième cage Faraday. Cette deuxième cage de Faraday permet ainsi de protéger les autres organes du véhicule automobile contre un rayonnement CEM des composants électroniques 3B de la carte à circuit imprimé 3 qui se trouvent sur sa première face 3A', mais elle permet également de protéger ces composants électroniques 3B eux-mêmes contre un rayonnement CEM des autres organes du véhicule automobile.

On notera que sans la présence des deuxièmes points de contact 7A", si la carte à circuit imprimé 3 (et donc la première ceinture de masse 3C) reposait directement sur la deuxième zone de contact 7A' du capot de protection 7, il pourrait y avoir des fuites CEM. En effet, il peut y avoir des défauts de planéité de la deuxième zone de contact 7A' et/ou de la première ceinture de masse 3C qui peut entraîner l'apparition d'une zone de non contact entre deux zones de contact.

Dans un mode de réalisation non limitatif illustré à la figure 3, les deuxièmes points de contact 7A" ont une forme arrondie. C'est une forme facile à mouler.

Dans un mode de réalisation non limitatif, les deuxièmes points de contact 7A" sont régulièrement répartis sur la deuxième zone de contact 7A'.

Dans un mode de réalisation non limitatif, les deuxièmes points de contact 7A" s'étendent sur le pourtour du capot de protection 7 de sorte qu'ils se retrouvent en regard de la première ceinture de masse 3C de la carte à circuit imprimé 3 lorsque cette dernière se trouve dans le boîtier 5 et que le capot de protection 7 est placé sur le boîtier 5 pour le fermer.

Comme il est illustré à la figure 3, tout ou partie des deuxièmes points de contact 7A" sont ainsi alignés entre eux avec un pas P' constant. Dans un exemple non limitatif, le pas P' est compris entre 3 et 5mm (millimètres). La répartition de pression est ainsi constante sur la carte à circuit imprimé 3 lors de la fermeture du boîtier 5 par le capot de protection 7.

On favorise ainsi un maintien équilibré de la carte à circuit 3 imprimé dans le boîtier 5. Dans un mode de réalisation non limitatif, les deuxièmes points de contact 7A" sont moulés avec le capot de protection 7 et plus particulièrement avec la deuxième zone de contact 7A'.

Dans un mode de réalisation non limitatif, les deuxièmes points de contact 7A" sont en Zamak. L'utilisation du Zamak facilite le moulage des deuxièmes points de contact 7A" à la géométrie souhaitée. En outre, avec le Zamak les deuxièmes points de contact 7A" présentent une excellente dureté.

Ainsi, grâce aux premiers points de contacts 5A" coopérant avec la deuxième ceinture de masse 3D et aux deuxièmes points de contacts 7A" coopérant avec la première ceinture de masse 3C, on assure une reprise de masse entre l'enveloppe métallique du dispositif de pilotage 10 (formée par le boîtier 5 et le capot de protection 7) et le circuit électrique du dispositif de pilotage 10, à savoir la carte à circuit imprimé 3. Le boîtier 5, le capot de protection 7 et la carte à circuit imprimé 3 sont tous reliés à la même masse de sorte à réaliser un blindage CEM. Cela améliore la qualité du blindage CEM.

### ∘ Deuxième muret de protection 7B'

Le deuxième muret de protection 7B' s'étend verticalement à partir du deuxième corps de base 7A. Le deuxième muret de protection 7B' est adapté pour s'emboîter avec le premier muret de protection 5B' du boîtier 5. Il existe ainsi une zone de recouvrement 9 entre le boîtier 5 et le capot de protection 7 comme décrit précédemment.

Grâce à la zone de recouvrement 9, le deuxième muret de protection 7B' est adapté pour réaliser une barrière complémentaire de protection CEM pour les composants électroniques 3B de la carte à circuit imprimé 3, en particulier pour ceux situés sur la première face 3A'.

Enfin, comme pour le cas du premier muret de protection 5B' avec tout ou partie des premiers points de contact 5A", le deuxième muret de protection 7B' agit comme un moyen de protection de tout ou partie des deuxièmes points de contact 7A" au cours de la fabrication du capot de protection 7. En effet, au cours de cette fabrication le capot de protection 7 est également soumis comme le boîtier 5, après son injection à l'opération de dégrapage vue précédemment et à l'opération d'ébavurage vue précédemment. Les deuxièmes points de contact 7A" qui sont protégés par le deuxième muret de protection 7B' ne sont pas enlevés ou abîmés et conservent ainsi leur forme pendant la fabrication du capot de protection 7.

Dans un mode de réalisation non limitatif illustré sur la figure 3, une partie des deuxièmes points de contacts 7A" sont protégés par le deuxième muret de protection 7B'. Ils sont situés en bas dudit deuxième muret de protection 7B'. Les autres deuxièmes points de contacts 7A" qui ne sont pas protégés sont ceux qui se trouvent en regard du connecteur bord de carte 11 lorsque ce dernier est installé. Bien entendu, dans un autre mode de réalisation non limitatif, on peut prévoir de les protéger également.

On notera qu'après l'opération d'ébavurage, dans un mode de réalisation non limitatif, le capot de protection 7 subit une opération de nettoyage qui permet d'enlever la graisse utilisée pour l'opération de démoulage.

### ∘ Partie de protection 7C

La partie de protection 7C est adaptée pour venir couvrir la piste de connexion 3F de la carte à circuit imprimé 3. Pour cela elle s'étend horizontalement en saillie du deuxième corps de base 7A du capot de protection 7, comme illustré sur les figures 1 ou 7.

### • Vis

La vis 8 est adaptée pour fixer le capot de protection 7 sur le boîtier 5. Elle maintient le capot de protection 7 sur le boîtier 5.

La tête de la vis 8 est adaptée pour reposer sur le capot de protection 7 lorsque le capot de protection 7 vient fermer le boîtier 5. Elle est ainsi adaptée pour maintenir fermé ledit boîtier 5. Le filetage de la vis 8 est adapté pour se loger dans le trou taraudé 5A'" du boîtier 5.

La vis 8 assure le plaquage de la carte à circuit imprimé 3 dans le boîtier 5 et assure ainsi que les premiers points de contact 5A" du boîtier 5 et les deuxièmes points de contacts 7A" du capot de protection 7 sont bien en contact avec respectivement la deuxième ceinture de masse 3D et la première ceinture de masse 3C de la carte à circuit imprimé 3.

### • Procèdè de montage

Le procédé de montage du dispositif de pilotage 10 est décrit en référence aux figures 10 à 14.

Dans un premier temps, on vient insérer la carte à circuit imprimé 3 dans le boîtier 5 (figure 10). La deuxième face 3A" de la carte à circuit imprimé 3 repose alors sur la première zone de contact 5A' du boitier 5 et les premiers points de contact 5A" sont en contact avec la deuxième ceinture de masse 3D.

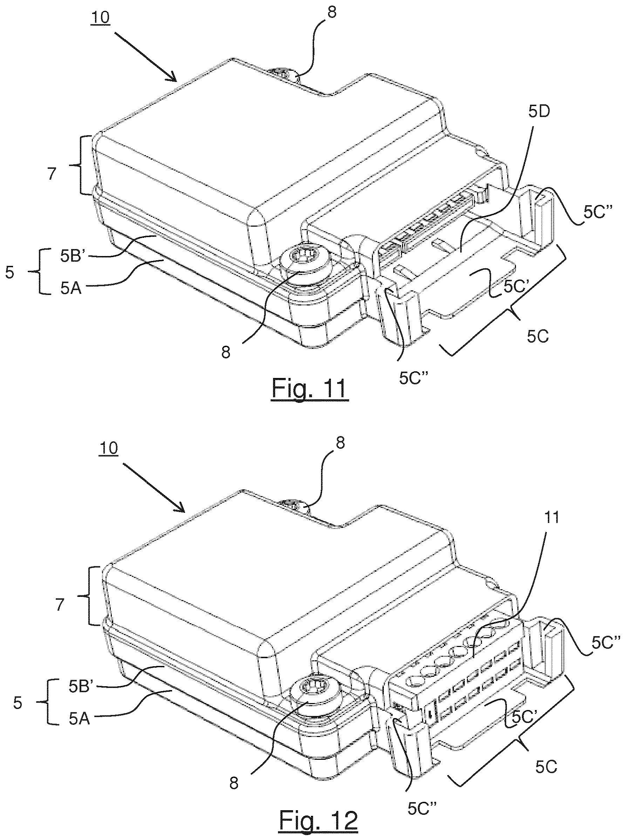

Dans un deuxième temps, on vient rapporter le capot de protection 7 sur le boitier 5 (figure 11). Les deuxièmes points de contact 7A" du capot de protection viennent en contact avec la première ceinture de masse 3C. La zone de recouvrement 9 est formée entre le boîtier 5 et le capot de protection 7. Puis, la vis 8 est insérée dans l'orifice 7A'" du capot de protection 7 et dans l'orifice 3G de la carte à circuit imprimé 3 et elle est vissée dans le trou taraudé 5A'" du boitier 5 (figure 11).

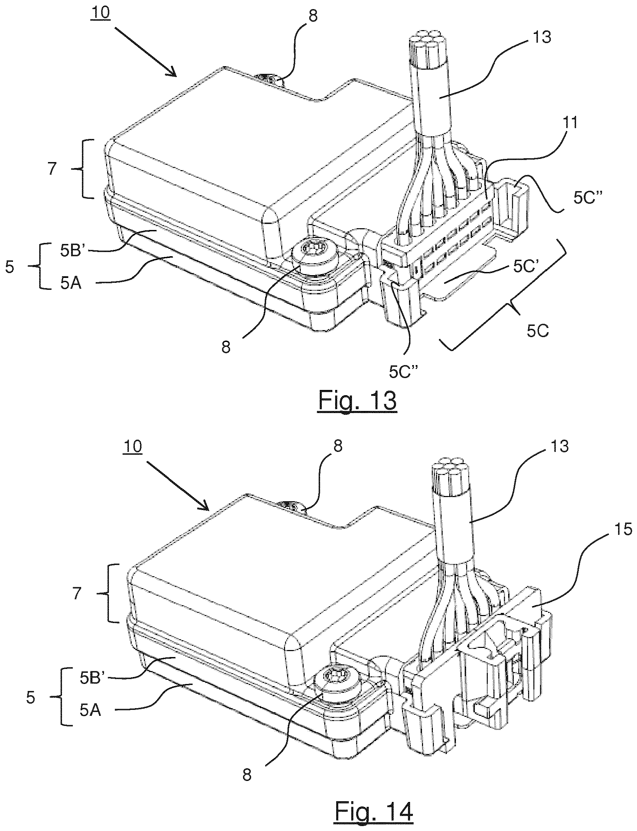

Dans un troisième temps, on vient placer le connecteur bord de carte 11 sur la zone de réception 5C du boitier 5. Le connecteur bord de carte 11 vient alors s'accrocher à la carte à circuit imprimé 3 par sa mâchoire (figure 12). Le connecteur bord de carte 11 se retrouve en partie sous la partie de protection 7C du capot de protection 7. Le faisceau d'alimentation est ensuite relié au connecteur bord de carte 11 (figure 13).

Enfin, la pièce de blocage 15 est glissée dans la glissière verticale 5C" pour venir bloquer le connecteur bord de carte 11 dans le dispositif de pilotage 10 (figure 14).

Le dispositif de pilotage 10 est ainsi assemblé.

Après assemblage de ses pièces, le dispositif de pilotage 10 est monté sur le module lumineux.

Bien entendu, la description de l'invention n'est pas limitée aux modes de réalisation décrits ci-dessus.

Ainsi, dans un autre mode de réalisation non limitatif, le boîtier 5 et le capot de protection 7 ainsi que leurs premiers point de contact 5A" et leurs deuxièmes points de contact 7A"sont dans un matériau plus ou moins durs que le Zamak.

Ainsi, dans un autre mode de réalisation non limitatif, le boîtier 5 et le capot de protection 7 sont en aluminium, ainsi que leurs premiers point de contact 5A" et leurs deuxièmes points de contact 7A".

Ainsi, dans un autre mode de réalisation non limitatif, le nombre de vis 8 est supérieur ou égal à deux.

Ainsi, dans un autre mode de réalisation non limitatif, la fabrication du dispositif de pilotage 10 ne comporte pas d'opération de dégrapage. Cela est le cas lorsque le boîtier 5 et le capot de fabrication 7 ne sont pas dans le même moule.

Ainsi, l'invention décrite présente notamment les avantages suivants :
- elle présente une architecture différente de celle de l'état de la technique antérieur avec le pion de sertissage ;
- elle supprime des étapes d'assemblage (à savoir le sertissage d'un pion de sertissage) puisque dorénavant la reprise de masse se fait en même temps que la fermeture du boîtier 5 ;
- elle réduit les risques de détérioration des composants électroniques de la carte à circuit imprimé 3 ;
- l'utilisation du Zamak permet de réduire les coûts de fabrication du dispositif de pilotage 10, notamment lorsque ce dernier est de format relativement petit car l'injection Zamak est moins chère que l'injection aluminium ;
- l'injection Zamak autorise des pièces plus précises et plus techniques avec des mouvements plus faciles à mettre en oeuvre dans le moule ainsi que l'assurance d'avoir des points de contact plus durs avec la géométrie souhaitée ;
- elle permet de limiter les émissions CEM du dispositif de pilotage 10 ;
- elle permet de protéger le dispositif de pilotage 10 contre les émissions CEM provenant d'autres organes du véhicule automobile ;
- les premiers et deuxièmes points de contact 5A", 7A" sont protégés respectivement par au moins muret de protection 5B', 7B' lors de chaque opération de fabrication du boîtier 5 et du capot de protection 7, murets de protection qui servent aussi de barrière CEM ;
- le reste de l'étanchéité CEM du dispositif de pilotage 10 est assurée par le recouvrement du boitier 5 par le capot de protection 7.

## Revendications

1. Dispositif de pilotage (10) de l'alimentation électrique pour une source lumineuse à semi-conducteur pour un module lumineux, le dispositif de pilotage (10) comportant :
- une carte à circuit imprimé (3) comportant au moins un composant électronique (3B) pour le pilotage de l'alimentation électrique ;
- un boîtier (5) adapté pour accueillir ladite carte à circuit imprimé (3) ;
- un capot de protection (7) pour fermer ledit boîtier (5) ;
- une première ceinture de masse (3C) disposée sur une première face (3A') de ladite carte à circuit imprimé (3) et une deuxième ceinture de masse (3D) disposée sur une deuxième face (3A") de ladite carte à circuit imprimé (3) opposée à la première face (3A') ;
- ledit capot de protection (7) et ledit boîtier (5) étant en aluminium, le boitier (5) comportant des premiers points de contact (5A") avec la deuxième ceinture de masse (3D) et ledit capot de protection (7) comportant des deuxièmes points de contact (7A") avec ladite première ceinture de masse (3C), ledit boitier (5) et/ou ledit capot de protection (7) comprenant au moins un muret de protection (5B', 7B') pour tout ou partie desdits premiers (5A") et deuxièmes points de contact (7A"), les premiers points de contact (5A") et les deuxièmes points de contact (7A") ayant une forme arrondie et les premiers points de contact (5A") et les deuxièmes points de contact (7A") étant moulés respectivement avec le boîtier (5) et le capot de protection (7).

2. Dispositif de pilotage (10) selon la revendication 1, dans lequel les premiers points de contact (5A") et les deuxièmes points de contact (7A") sont régulièrement répartis respectivement sur une première zone de contact (5A') et sur une deuxième zone de contact (7A') dudit boitier (5) et dudit capot de protection (7) avec ladite carte à circuit imprimé (3).

3. Dispositif de pilotage (10) selon l'une des revendications 1 à 2, dans lequel ledit dispositif de pilotage (10) comprend au moins une vis (8) adaptée pour maintenir fermé ledit boîtier (5).

4. Dispositif de pilotage (10) selon l'une des revendications 1 à 3, dans lequel ledit boîtier (5) et/ou ledit capot de protection (7) comprend une zone chanfreinée primaire (7A‴).

5. Dispositif de pilotage (10) selon l'une des revendications 1 à 4, dans lequel il existe une zone de recouvrement (9) entre ledit boîtier (5) et ledit capot de protection (7) lorsque ledit boîtier (5) est fermé par ledit capot de protection (7).

6. Dispositif de pilotage (10) selon la revendication 5, dans lequel ladite zone de recouvrement (9) comprend une hauteur supérieure ou égale à 1mm.

7. Dispositif de pilotage (10) selon l'une des revendications 1 à 6, dans lequel la source lumineuse à semi-conducteur fait partie d'une diode électroluminescente.

8. Module lumineux pour véhicule automobile dans lequel ledit module lumineux comprend une source lumineuse à semi-conducteur et un dispositif de pilotage (10) de l'alimentation électrique pour ladite source lumineuse à semi-conducteur selon l'une quelconque des revendications précédentes 1 à 7.

## Patentansprüche

1. Vorrichtung (10) zur Steuerung der Stromversorgung für eine Halbleiter-Lichtquelle für ein Leuchtmodul, wobei die Steuerungsvorrichtung (10) Folgendes umfasst:
- eine gedruckte Leiterplatte (3) mit mindestens einem elektronischen Bauteil (3B) zur Steuerung der Stromversorgung;
- ein Gehäuse (5), das die gedruckte Leiterplatte (3) aufnehmen kann:
- eine Schutzabdeckung (7) zum Verschließen des Gehäuses (5);
- einen ersten Erdungsgurt (3C), der auf einer ersten Seite (3A) der Leiterplatte (3) angeordnet ist, und einen zweiten Erdungsgurt (3D), der auf einer zweiten Seite (3A") der Leiterplatte (3) gegenüber der ersten Seite (3A') angeordnet ist; wobei die Schutzabdeckung (7) und das Gehäuse (5) aus Aluminium bestehen,
wobei das Gehäuse (5) erste Kontaktpunkte (5A") mit dem zweiten Erdungsgurt (3D) aufweist und die Schutzabdeckung (7) zweite Kontaktpunkte (7A") mit dem ersten Erdungsgurt (3C) aufweist,
wobei das Gehäuse (5) und/oder die Schutzabdeckung (7) mindestens eine Schutzmauer (5B', 7B') für alle oder einen Teil der ersten (5A") und zweiten Kontaktpunkte umfasst.

2. Steuervorrichtung (10) nach Anspruch 1, bei der die ersten Kontaktpunkte (5A") und die zweiten Kontaktpunkte (7A") gleichmäßig über eine erste Kontaktzone (5A') bzw. über eine zweite Kontaktzone (7A') des Gehäuses (5) und der Schutzabdeckung (7) mit der Leiterplatte (3) verteilt sind.

3. Treibervorrichtung (10) nach einem der Ansprüche 1 bis 2, wobei die Treibervorrichtung (10) mindestens eine Schraube (8) umfasst, die geeignet ist, das Gehäuse (5) geschlossen zu halten.

4. Treibervorrichtung (10) nach einem der Ansprüche 1 bis 3, wobei das Gehäuse (5) und/oder die Schutzabdeckung (7) einen primären abgeschrägten Bereich (7A‴) aufweist.

5. Treibervorrichtung (10) nach einem der Ansprüche 1 bis 4, wobei zwischen dem Gehäuse (5) und der Schutzhaube (7) ein Überlappungsbereich (9) vorhanden ist, wenn das Gehäuse (5) durch die Schutzhaube (7) verschlossen ist.

6. Steuervorrichtung (10) nach Anspruch 5, wobei der Überlappungsbereich (9) eine Höhe von größer oder gleich 1 mm umfasst.

7. Treibervorrichtung (10) nach einem der Ansprüche 1 bis 6, wobei die Halbleiterlichtquelle Teil einer lichtemittierenden Diode ist.

8. Lichtmodul für ein Kraftfahrzeug, wobei das Lichtmodul eine Halbleiterlichtquelle und eine Treibervorrichtung (10) für die Stromversorgung für die Halbleiterlichtquelle nach einem der vorhergehenden Ansprüche 1 bis 7 umfasst.

## Claims

1. A power supply driver device (10) for a semiconductor light source for a light module, the drive device (10) comprising:
- a printed circuit board (3) comprising at least one electronic component (3B) for driving the power supply;
- a housing (5) adapted to accommodate said printed circuit board (3):
- a protective cover (7) to close said housing (5);
- a first ground belt (3C) arranged on a first face (3A) of said printed circuit board (3) and a second ground belt (3D) arranged on a second face (3A") of said printed circuit board (3) opposite to the first face (3A'); said protective cover (7) and said housing (5) being made of aluminum,
the housing (5) having first contact points (5A") with the second ground belt (3D) and said protective cover (7) having second contact points (7A") with said first ground belt (3C),
said housing (5) and/or said protective cover (7) comprising at least one protective wall (5B', 7B') for all or part of said first (5A") and second contact points.

2. Driver device (10) according to claim 1, in which the first contact points (5A") and the second contact points (7A") are evenly distributed respectively over a first contact zone (5A') and over a second contact zone (7A') of said housing (5) and said protective cover (7) with said printed circuit board (3).

3. Driver device (10) according to one of claims 1 to 2, wherein said pilot device (10) comprises at least one screw (8) adapted to hold said housing (5) closed.

4. Driver device (10) according to one of claims 1 to 3, wherein said housing (5) and/or said protective cover (7) comprises a primary chamfered area (7A‴).

5. Driver device (10) according to one of claims 1 to 4, wherein there is an overlap zone (9) between said housing (5) and said protective cover (7) when said housing (5) is closed by said protective cover (7).

6. Driver device (10) according to claim 5, wherein said overlap zone (9) comprises a height greater than or equal to 1 mm.

7. Driver device (10) according to one of claims 1 to 6, wherein the semiconductor light source is part of a light-emitting diode.

8. A light module for a motor vehicle in which said light module comprises a semiconductor light source and a power supply driver device (10) for said semiconductor light source according to any one of the preceding claims 1 to 7.
